# EUROPEAN PATENT APPLICATION

(11) **EP 3 355 096 A1**
(43) Date of publication of application: **01.08.2018**
(21) Application number: 18153037.9
(22) Date of filing: 23.01.2018
(51) Int. Cl.: G02B 27/01, B60K 35/00

(54) **DISPLAY SYSTEM FOR A VEHICLE**

(30) Priority: 30.01.2017 DE 102017101699
(71) Applicant: Visteon Global Technologies, Inc., Van Buren Township, MI 48111-5711 (US)
(72) Inventor: VAN LAACK, Alexander, 52072 Aachen (DE); CITTADINI, Ruddy, 50823 Köln (DE); BELZL, Frederik, 50737 Köln (DE)
(74) Representative: Dummett Copp LLP

(57) **Abstract**

The invention relates to a display system (1) for a vehicle, comprising a screen (2) and at least one projection surface. A surface of the screen (2) is bent in such a manner that at least one curved surface (2-1) and a second curved surface (2-2) are formed. The first curved surface (2-1) on which information can be displayed is arranged aligned in the direction of an observer. The second curved surface (2-2) is constructed in such a manner that information to be displayed on the second curved surface (2-2) can be projected in the direction of the at least one projection surface. The projection surface is at a distance from the second curved surface (2-2) and is arranged so that it can be seen behind the screen (2) by the observer in the direction of the view of the observer.

## Description

The invention relates to a display system for a vehicle with a screen and at least one projection surface.

Traditional vehicles have a greater and greater number of separate screens, signal displays and warning indicators which must be arranged so that they are readily accessible and readily visible for the vehicle driver in the cabin, in particular on the dashboard. The vehicles are constructed with one or more combination instruments, a head-up display and optionally with side displays for an interaction of the vehicle driver with, for example systems of the vehicle, or to reproduce information. The large number of screens and displays in the vehicle makes it difficult to arrange them in a readily understandable manner for the vehicle driver, which, however, is important so as not to adversely affect the concentration of the vehicle driver during driving. It is therefore desirable to show the needed information via a common display system.

It is known from the prior art to project information into the field of sight of a vehicle driver such as a car driver or a pilot by a head-up display. The term head-up display, also abbreviated as HUD, denotes a display system in which the user can substantially retain the holding of his head or the direction of sight in the original alignment in order to view the displayed information. Such head-up displays generally comprise an image-generating unit which makes the information to be shown available in the form of an image, an optical module which makes possible the beam course inside the head-up display to an exit opening and is also designated as a mirror lens, and a projection surface for showing the image to be generated. The optical module conducts the image onto the projection surface, which is constructed as a reflecting, light-permeable disk and can also be designated as a combiner. The vehicle driver sees the reflected information of the image-generating unit and at the same time the actual surroundings behind the disk. Therefore, the attention of the vehicle driver, for example when driving a motor vehicle, remains directed onto what is taking place in front of the vehicle while he can detect the information projected into the field of sight.

In order to minimize the expense for the manufacture and development and to ensure an improved interaction with a passenger of the vehicle, the number of displays should be reduced. Even for reasons of operating friendliness and for reasons of space, vehicle manufacturers try to design displays or display systems in such a manner that several contents, pieces of information or image information can be displayed by one display system. The attempt is therefore made to make image information presentable at different levels which can be perceived by an observer at different depths or distances.

DE 10 2005 035 645 B4 describes a display device for a vehicle, in particular a display device for projecting a combination of direct and reflected images into the sight range of a vehicle driver.

DE 10 2008 002 235 A1 teaches a projection display device for a vehicle which comprises at least one imaging lens and at least one micromirror display for displaying information and/or for switching an optical beam path onto optical paths.

As regards the efficiency, it would be advantageous to make a display system available with as many functions as possible in order to minimize, in addition to the required structural space, also the total costs for individual components and the integration and the complexity.

The present invention has the problem of reducing the number of the screens used in a vehicle without adversely affecting the operability and the access to important information for the vehicle driver.

The present invention solves the problem by a display system for a vehicle with a screen and at least one projection surface.

According to the concept of the invention, the screen has a curved surface which is constructed with a first curved surface and a second curved surface. The first curved surface, on which information can be displayed, is arranged aligned in the direction of an observer, in particular of a vehicle driver. The second curved surface is constructed in such a manner that information which can be displayed on the second curved surface can be projected in the direction of the at least one projection surface. The projection surface is at a distance from the second curved surface and is arranged so that it can be seen by the observer from a direction of view of the observer, behind the screen.

The second curved surface is advantageously arranged so that it is not visible to the observer.

According to a further development of the invention the surface of the screen is constructed to be bent in such a manner that a rise in the curvature of the first surface which is curved upward in the vertical direction becomes greater as the distance from the observer becomes greater, subsequently remains constant and becomes less in a curvature range and *vice versa.*

The term *vice versa* denotes here that the rise is zero at a reversing point of the curvature area and becomes negative in the further course along the image screen. After the reversal point of the area of curvature the surface of the screen is constructed to be bent downward in the vertical direction so that the second curved surface is arranged aligned in downward in the vertical direction. The first curved surface and the second curved surface are opposite one another in the viewing direction of the observer and arranged turned away from one another, wherein the observer can look at the first curved surface and the second curved surface is hidden from him.

The screen is preferably constructed from a flexible material, in particular from organic light-emitting diodes, also as organic light-emitting diodes abbreviated as OLEDs. Organic light-emitting diodes are structural elements with a thin layer consisting of organic, semi-conductive materials. The construction of the screen as an OLED screen has the additional advantage of showing data and information without an edge.

The screen can be advantageously designated as a combination instrument as well as a cluster, and can be used for projecting information onto a projection surface such as a projection surface of a head-up display or as a front pane of the vehicle similar to a head-up display.

The projection surface serves for the superposing and/or combining of information about the surroundings of the vehicle with information in the form of a head-up display generated especially by the second curved surface. Consequently, the display system can be used as a combination instrument and/or as a head-up display. Therefore, the needed information can be shown selectively either on the first curved surface, on the projection surface of a head-up display and/or on the front pane of the vehicle to the vehicle driver.

The term projection surface of the head-up display, also designated as a combiner surface, denotes a light-permeable, reflecting disk preferably consisting of glass or plastic. The combiner surface is constructed as a semi-transparent mirror.

The screen is preferably bent in such a manner that two side edges arranged in parallel describe an arc whereas two other side edges, which are also advantageously arranged in parallel, are fixed on a vehicle dashboard.

According to an advantageous embodiment of the invention the first curved surface of the screen merges inside the area of curvature into the second curved surface.

According to another preferred embodiment of the invention the area of curvature being produced by the bending of the screen is constructed in such a manner as to show other information adjacent to the information of the first curved surface and the information of the second curved surface.

The information which can be shown in the area of curvature of the screen can be directly viewed and/or projected onto a front pane of the vehicle. The light beams which are radiated or emitted in the area of curvature of the screen for showing the information and are directed toward the front pane of the vehicle are especially suitable for showing Meta-HMI data. Meta-HMI images are simple visual representations of information which are produced, for example, by lights in different colors and make additional information available to the vehicle driver. The term HMI denotes human-machine interfaces.

According to a further development of the invention, the screen is constructed as a color screen. Therefore, the information projected onto the projection surface, that is, onto the projection surface of the head-up display or onto the front pane can be characterized by different colors. As a result, for example warning indicators can be characterized especially in color.

The advantageous design of the invention, especially as regards the space-saving and simple construction, makes it possible to use the display system inside a vehicle in particular for showing vehicle parameters, for example the speed, engine temperature, oil level and/or problem indicators/warning lights and/or information about vehicle assistance systems, for example an audio system such as a radio or CD player, distance detectors, a navigation system and/or a (driving) lane recognition system. The display system can be integrated in a space-saving manner, for example into the dashboard of the vehicle. The information and data can be represented then as text or as images.

The display according to the invention has the additional advantage that all essential information about the vehicle or from vehicle assistance systems can be shown with a display system, wherein the complexity of the devices in the passenger compartment and therefore the manufacturing costs are reduced.

In addition, it is made possible for the vehicle driver by the type of the representation of the information to perceive the information without stopping to look at the surroundings around him, in particular the road, and thus adversely influencing the concentration of the vehicle driver when driving.

In sum, the display system according to the invention, designed as a combination instrument and a head-up display, comprises various other advantages:
- It loads a very small structural space, in particular by the using of the flexible screen and is therefore ideally suited for inclusion into a vehicle dashboard in order to show information to the observer, in particular to the vehicle driver;
- It has a simple construction which does not require any deflection mirror or imaging mirror, in particular by the design of the curved or corrugated surfaces of the screen;
- It has a single screen, which lowers the costs of manufacture and of assembly and improves the interaction with the vehicle passengers and furthers the reproduction of the information in a rapid and reliable manner;
- The flexible design of the screen, for example, as an OLED, makes possible alternative solutions of the arrangement and an edgeless design;
- Information to be represented can be exchanged and transmitted between the first curved surface as an area of the combination instrument and between the second curved surface as an area of the head-up display in a simple, in particular flowing manner since the areas are associated with a screen; and
- The Meta-HMI images emitted on the surface of the display system are reflected to the observer in a directly visibly manner or on the front pane of the vehicle, which generates a virtual image in the view field of the observer.

The invention will now be further described, by way of example only, and with reference to the accompanying drawings, in which:
Figure 1 shows a schematic view of a display system for generating a virtual image with a head-up display in a side view;
Figure 2 shows a schematic view of a display system for generating a virtual image with the head-up display and an additional, virtual Meta-HMI image in a side view; and
Figure 3 shows a schematic view of a display system for generating a virtual image with the head-up display in a perspective view.

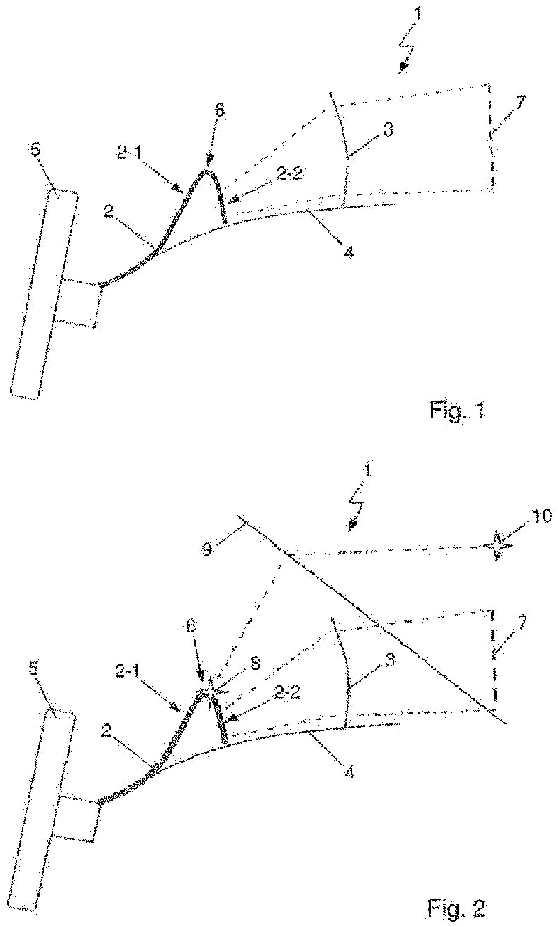

Figures 1 and 2 show a schematic view of a display system 1. The display system 1 comprises a flexible screen 2 and a projection surface 3 which are arranged integrated in a dashboard 4.

The surface of the screen 2 of the display system 1 is bent or curved, wherein the surface in an area facing a steering wheel 5 runs flatly at first and rises steeply in the vertical direction as the distance from the steering wheel 5 increases so that a first curved surface 2-1 is formed.

In addition, the surface of the screen 2 is bent in such a manner that the rise of the curvature of the first curved surface 2-1 becomes greater as the distance from the steering wheel 5 becomes greater, subsequently remains constant and is reduced in a curvature area 6. The surface of the screen 2 is bent down at a steep angle in the upper area, that is, the curvature area 6. The first curved surface 2-1 of the screen 2 merges into a second curved surface 2-2 inside the curvature area 6.

The curvature area 6 is formed as the upper area or reversal area of the screen 2 by the bending or curvature of the screen 2 between the first curved surface 2-1 and the second curved surface 2-2. The first curved surface 2-1 and the second curved surface 2-2 of the screen merge into one another and the surfaces 2-1, 2-2 lie against one another in the curvature area 6. The designation reversal area refers here to the reversal of the rise of the curvature.

The information shown on the second curved surface 2-2 is projected onto the projection surface 3 designed as a reflecting, light-permeable disk or as a semi-transparent mirror which is arranged in such a manner that a virtual HUD image 7 is produced in the direction of view of a vehicle driver behind the projection surface 3 of the head-up display. The projection surface 3 is designed to be reflecting for the image information made available by the second curved surface 2-2 so that the vehicle driver who is looking over the steering wheel 5 at the projection surface 3 perceives the image information radiated from the second curved surface 2-2 as the virtual HUD image 7.

In addition, the curvature area 6 of the screen 2 projects in a vertical direction above an upper area of the steering wheel 5 so that the vehicle driver can see the curvature area 6 of the screen 2 above the steering wheel 5 and can perceive Meta-HMI information 8 shown in the curvature area 6. In addition, the curvature area 6 can be constructed in such a manner that it projects the Meta-HMI information 8 onto a front pane 9 of the vehicle so that a virtual Meta-HMI image 10 is produced on the front pane 9 in the visible area of the vehicle driver, which is particularly apparent from Figure 2.

Meta-HMI also includes a warning if, for example, a light is lit in front of a pedestrian or for a passing automobile which appears within a certain danger zone. Meta-HMI can also be used for a warning before an impact, that is, a collision. Such a light or a simple display above an image sign or a symbol can be reflected via the front pane 9 or other surface. The Meta-HMI displays the information here only indirectly and therefore does not need to be a very sharp or exact display.

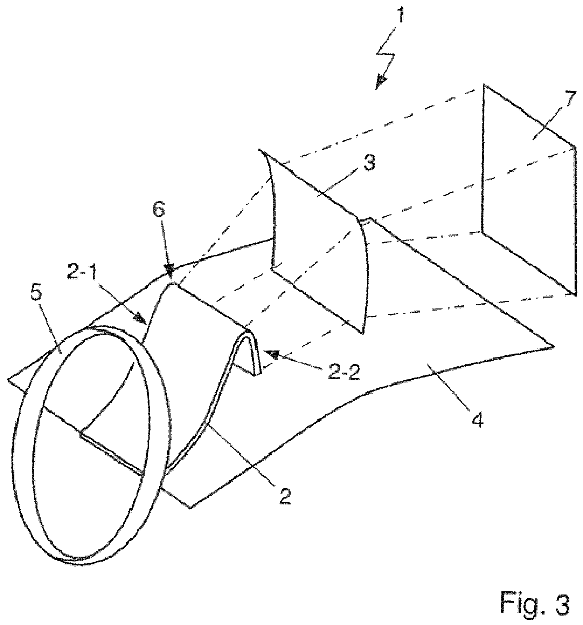

Figure 3 shows a schematic view of the display system 1 for generating a virtual HUD image 7 with the head-up display in a perspective view in order to illustrate the surfaces of the dashboard 4 and of the screen 2, in particular the bending of the flexible screen 2.

As is especially evident from Figure 3, the projection surface 3 is also designed with a curved surface.

When used in a vehicle, the display system 1, in particular the screen 2, is additionally connected to a control unit or computer unit which serves to make the information available which is to be displayed on the screen 2. The computer unit is connected, for example, to the driving assistance systems constructed in the vehicle and to sensors and detectors which serve to determine vehicle parameters.

The computer unit also determines which data and information are displayed on the first curved surface 2-1 of the screen 2 and which data and information are displayed on the second curved surface 2-2 of the screen 2 and therefore by the head-up display. At least one operating element such as a switch, a rotary button or the like is constructed, for example, on the dashboard 4 or in the area of the steering wheel 5 which makes it possible for the vehicle driver to adjust the method of displaying information. In addition, vehicle parameters can be changed or adapted or vehicle assistance systems can be operated by the vehicle driver by the combination of the display system 1, the control unit and the operating element.

Furthermore, the screen 2 can also be constructed as a touch-sensitive screen so that an input by the vehicle driver can take place directly via the screen.

### List of reference numerals

- 1: display system
- 2: screen
- 2-1: first curved surface
- 2-2: second curved surface
- 3: projection surface
- 4: dashboard
- 5: steering wheel
- 6: curvature area
- 7: virtual HUD image
- 8: Meta-HMI information
- 9: front pane
- 10: virtual Meta-HMI image

## Claims

1. A display system (1) for a vehicle, comprising a screen (2) and at least one projection surface, **characterized in that** a surface of the screen (2) is designed to be bent and comprises at least one first curved surface (2-1) and a second curved surface (2-2, wherein:
- the first curved surface (2-1) on which information can be displayed is arranged aligned in the direction of an observer; and
- the second curved surface (2-2) is constructed in such a manner that information to be displayed on the second curved surface (2-2) can be projected in the direction of the at least one projection surface, wherein the projection surface is at a distance from the second curved surface (2-2) and is arranged so that it can be seen behind the screen (2) by the observer in the direction of the view of the observer.

2. The display system (1) according to Claim 1, **characterized in that** the surface of the screen (2) is constructed bent in such a manner that a rise in the curvature of the first surface (2-1) curved upward in a vertical direction becomes greater as the distance from the observer becomes greater, is subsequently held constant and is reduced in a curvature area (6) and *vice versa,* wherein the surface of the screen (2) is bent downward in the curvature area (6) in a vertical direction so that the second curved surface (2-2) is arranged aligned downward in a vertical direction.

3. The display system (1) according to Claim 2, **characterized in that** the first curved surface (2-1) of the screen (2) merges within the curvature area (6) into the second curved surface (2-2).

4. The display system (1) according to any one of Claims 1 to 3, **characterized in that** the screen (2) is formed from aa flexible material.

5. The display system (1) according to Claim 4, **characterized in that** the screen (2) is formed from organic light-emitting diodes.

6. The display system (1) according to any one of Claims 1 to 5, **characterized in that** a projection surface (3) of a head-up display is formed as projection surface.

7. The display system (1) according to one of Claims 1 to 5, **characterized in that** a front pane (9) of a vehicle is formed as projection surface.

8. The display system (1) according to any one of Claims 1 to 7, **characterized in that** a curved area (6) of the screen (2) is formed in such a manner as to display information adjacent to the information of the first curved surface (2-1) and the information of the second curved surface (2-2).

9. The display system (1) according to Claim 8, **characterized in that** information which can be displayed in the curved area (6) of the screen (2) can be projected onto a front pane (9) of a vehicle.

10. The use of the display system (1) according to any one of Claims 1 to 9 in a vehicle.
